Europäisches Patentamt

(19) European Patent Office

Office européen des brevets

(11) Numéro de publication: **0 202 977**
**B1**

(12) **FASCICULE DE BREVET EUROPEEN**

(45) Date de publication du fascicule du brevet:
**12.07.89**

(51) Int. Cl.⁴: **C30B 13/34, C30B 13/24**

(21) Numéro de dépôt: **86400800.8**

(22) Date de dépôt: **15.04.86**

(54) **Procédé de fabrication sur un support isolant d'un film de silicium monocristallin orienté et à défauts localisés.**

(30) Priorité: **19.04.85 FR 8506000**

(43) Date de publication de la demande:
**26.11.86 Bulletin 86/48**

(45) Mention de la délivrance du brevet:
**12.07.89 Bulletin 89/28**

(84) Etats contractants désignés:
**DE GB IT NL**

(56) Documents cités:
**APPLIED PHYSICS LETTERS, vol. 41, no. 1, 1er juillet 1982, pages 64-67, American Institute of Physics, New York, US; J. SAKURAI et al.: "Laser-induced lateral epitaxial growth of silicon over silicon dioxide with locally varied encapsulation"**
**JOURNAL OF APPLIED PHYSICS, vol. 55, no. 6, 15 mars 1984, pages 1607-1609, American Institute of Physics, New York, US; S. KAWAMURA et al.: "Laser recrystallization of Si over SiO2 with a heat-sink structure"**

(73) Titulaire: **ETAT FRANCAIS représenté par le Ministre des PTT (Centre National d'Etudes des Télécommunications), 38-40 rue du Général Leclerc, F-92131 Issy-les-Moulineaux(FR)**

(72) Inventeur: **Haond, Michel, 5, rue d'Oisan, F-38240 Meylan(FR)**
Inventeur: **Bensahel, Daniel, 45, Avenue Alsace-Lorraine, F-38000 Grenoble(FR)**
Inventeur: **Dutartre, Didier, 4, Allée Brêt, F-38240 Meylan(FR)**

(74) Mandataire: **Mongrédien, André et al, c/o BREVATOME 25, rue de Ponthieu, F-75008 Paris(FR)**

## Description

La présente invention a pour objet un procédé de fabrication, sur un support isolant, d'un film de silicium monocristallin à défauts localisés, ayant par exemple une orientation cristallographique (100).

Elle s'applique en particulier dans le domaine de la fabrication des circuits intégrés MOS ou bipolaires, notamment à grande rapidité de fonctionnement, résistant aux radiations ionisantes et/ou fonctionnant sous haute tension et devant dissiper de fortes puissances. Elle s'applique aussi dans la réalisation des circuits de commande des écrans plats d'affichage matriciel sur des substrats amorphes transparents tels que le verre.

La technologie silicium sur isolant ou technologie SSI constitue une amélioration sensible par rapport aux techniques standard dans lesquelles les composants actifs des circuits intégrés sont réalisés directement sur un substrat monocristallin en silicium massif. En effet, l'emploi d'un corps isolant conduit à une forte diminution des capacités parasites entre la source et le substrat d'une part, et le drain et le substrat d'autre part, des composants actifs des circuits intégrés et donc à un accroissement de la vitesse de fonctionnement de ces circuits.

De plus, cette technologie SSI permet de diminuer fortement les charges parasites introduites dans les circuits intégrés fonctionnant sous radiations ionisantes, étant donné que ces radiations ne peuvent pas ioniser le support isolant à l'encontre d'un support en silicium massif. Par ailleurs, cette technologie permet une augmentation de la densité d'intégration des circuits intégrés du fait qu'elle permet notamment d'éviter le perçage (latch-up en terminologie anglo-saxonne) dû au claquage des jonctions de ces circuits intégrés.

Enfin, cette technologie conduit à une simplification notable des procédés de fabrication des circuits intégrés ainsi qu'à une meilleure tenue de ces circuits aux hautes tensions.

L'obtention de films semiconducteurs monocristallins et notamment de silicium sur des supports isolants a été longuement étudiée plus spécialement en vue de la fabrication d'écrans plats et de leurs circuits de commande sur des substrats amorphes transparents. Lorsque les premières expériences utilisant des faisceaux lasers ou des faisceaux d'électrons ont montré qu'il était possible de faire croître des grains de silicium en les chauffant et surtout en fondant le silicium déposé, grâce à une technique de microfusion de zone, alors un regain d'activité s'est développé en vue de l'obtention de films de silicium monocristallin sur un support isolant.

Ce regain d'intérêt s'est traduit par la recherche de techniques permettant de traiter rapidement des plaquettes de silicium type industriel et en particulier dans la recherche de dispositifs de chauffage dont le coût est inférieur à celui d'une source laser ou d'un canon à électrons. C'est ainsi qu'ont été utilisées les résistances de graphite ou encore des lampes à filament ou à arc. Ces dispositifs de chauffage ont notamment été décrits dans un article de M.W. GEIS et al paru dans Applied Physics Letters, 37, de mai 1980, p. 454, et dans la demande de brevet n° 2 532 783 du 7 septembre 1982.

Malheureusement, aucune de ces techniques de chauffage connues n'a permis de produire jusqu'à ce jour des films de silicium monocristallin sans défaut sur la totalité de la surface d'une plaquette de silicium de dimensions industrielles (100 mm de diamètre).

Toutes les expériences semblent montrer que, même avec des faisceaux d'énergie non cohérente qui permettent de recristalliser des plaquettes de silicium entières en un seul passage, il est difficile d'envisager de supprimer les défauts résiduels tels que les joints et sous-joints de grains ou autres dislocations ; ceci est d'autant plus vrai que les films de silicium sont des films minces, c'est-à-dire dont l'épaisseur est inférieure à 0,5 μm.

Par ailleurs, afin d'orienter le film semiconducteur recristallisé, on a tenté d'utiliser un fin réseau gravé dans le support isolant comme décrit dans l'article de M.M. GEIS et al. paru dans Appl. Phys. Lett., H, 35, de juillet 1979, p.71-74, intitulé "Crystallographic orientation of silicon on an amorphous substrate using an artificial surface - relief grating and laser crystallization". Malheureusement, les techniques employées en balayage de fusion de zones de silicium, telles que celles décrites dans l'article de M.W. GEIS et dans le document FR-A-2 532 783 cités ci-dessus, n'ont jamais permis d'obtenir des plaquettes de silicium recristallisées totalement orientées et sans défaut.

L'une des techniques la plus utilisée pour réaliser une couche de silicium monocristallin sur un support isolant consiste à former sur un substrat en silicium monocristallin d'orientation donnée, une couche d'oxyde de silicium notamment par oxydation thermique puis à déposer sur la couche d'oxyde de silicium une couche de silicium polycristallin et enfin à soumettre le film à un traitement thermique tel qu'un balayage d'une zone fondue du film afin de recristalliser le silicium.

Dans une telle technique, on a envisagé de réaliser dans la couche d'oxyde de silicium des ouvertures de manière à utiliser le substrat monocristallin comme germe de recristallisation afin d'orienter le film recristallisé et d'éviter sa désorientation qui sont les causes principales d'apparition de joints et de sous-joints de grains. Cette technique de germination a notamment été décrite dans l'article de M. FEN paru dans Appl. Phys. Lett., H, 38, de 1981, page 365.

Dans cette technique, il est apparu nécessaire de reproduire avec une période courte (inférieure à 500 μm) les ouvertures dites de germination dans la couche d'oxyde de silicium afin de ne pas perdre l'orientation de départ. Or, ceci a notamment pour inconvénient de nécessiter, après recristallisation du film de silicium, une étape d'oxydation localisée de ces zones de germination afin de bien isoler la couche semiconductrice recristallisée du substrat monocristallin et de pouvoir utiliser ensuite les différents avantages mentionnés ci-dessus sur la technologie SSI. De plus, ces zones oxydées entraînent une perte de place du fait qu'il ne sera pas possible de réaliser des circuits intégrés isolés les uns des autres sur ces zones oxydées.

Par ailleurs, on a étudié la formation et l'apparition des joints et sous-joints de grains dans le but de trouver des techniques de localisation de ces défauts dans des zones étroites où on ne fabriquerait pas les zones actives (les grilles des transistors) des circuits intégrés.

En particulier, par recristallisation du film semiconducteur sur le support isolant par la technique de balayage d'une zone fondue de silicium, on a notamment pu remarquer que les joints et sous-joints de grains se formaient dans les zones qui se solidifiaient en dernier après le passage de la zone fondue.

En utilisant dans cette technique de recris tallisation une source laser, où l'énergie peut être concentrée sur un spectre très étroit, il est possible de coupler plus ou moins l'énergie du faisceau laser avec le film semiconducteur et de chauffer plus ou moins telle ou telle zone dudit film par rapport à une autre. Ceci peut être réalisé, comme décrit dans la demande de brevet français n° 83 16396 (FR-A 2 553 437), en utilisant sur le film de silicium à recristalliser des bandes parallèles antiréfléchissantes, jouant le rôle de retardateur de cristallisation, et en calculant l'épaisseur des bandes antiréfléchissantes et des bandes réfléchissantes (bandes de silicium) afin d'ajuster l'énergie du faisceau laser interagissant avec le film de silicium.

En revanche, dans le cas de source de lumière incohérente, étant donné leur large spectre d'émission, il est difficile d'ajuster les épaisseurs des bandes réfléchissantes et antiréfléchissantes pour tenter de mettre en phase les ondes lumineuses frappant la structure. Cependant, comme décrit dans un article de M.W. GEIS et al., paru dans J. Electrochem. Soc. : Solid-State Science and Technology, 130, p. 1178-1183 de mai 1983, intitulé "Solidification-Front Modulation to Entraîn Subboundaries in Zone Melting Recrystallization of Si on SiO₂", on a utilisé des corps noirs ou des couches métalliques pour leurs propriétés réfléchissantes sur un large spectre.

De même, dans un article de D. BENSAHEL, et al., paru dans Electronics Letters du 23 juin 1983, vol. 19, n° 13, p. 464-466, intitulé "Localisation of defects on SOI films via selective recrystallization using halogen lamps", on a utilisé des couches déposées d'indice différent comme adaptation grossière d'indice de réfraction sans s'attacher à des épaisseurs minces et calibrées.

Dans un autre procédé de localisation des défauts résiduels dans le film de silicium recristallisé, on a modulé les isothermes de la zone fondue semiconductrice en utilisant une diffusion sélective de la chaleur dans le substrat sous-jacent, en faisant varier l'épaisseur de la couche d'oxyde de silicium supportant le film semiconducteur. Ce procédé utilisant comme source de chauffage une source laser a été décrit dans un article de S. KAWAMURA et al., paru dans J. Appl. Phys. 55 (6) du 15 mars 1984, p. 1607 à 1609, intitulé "Laser recryzallization of Si over SiO₂ with a heat-sink structure".

Lorsque l'on parvient à localiser les différents défauts de recristallisation du film de silicium, comme décrit précédemment, le principal problème restant encore est celui de l'orientation cristalline de ce film recristallisé. Si avec des faisceaux d'énergie non cohérente, le film recristallisé présente une texture (100) perpendiculaire au plan du film, dans le cas des faisceaux lasers, ce film n'est généralement pas orienté et on est donc obligé d'avoir recours à des ouvertures de germination vers le substrat monocristallin, pratiquées dans la couche d'oxyde de silicium. Avec des faisceaux d'énergie non cohérente cependant, le film de silicium reste désorienté dans le plan du film ; la désorientation est d'environ 30° par rapport à la direction de déplacement de la zone fondue.

Dans le cas des faisceaux d'énergie non cohérente, d'autres problèmes demeurent et notamment la tenue des films semiconducteurs lors de la fusion de zone. En effet, lorsque le silicium est liquide et en contact avec de l'oxyde de silicium, généralement utilisé comme support isolant, le silicium ne mouille pas l'isolant et a tendance à se mettre en goutte. Aussi, faut-il trouver un "encapsulant" efficace, c'est-à- dire un élément enfermant le film semiconducteur, permettant de maintenir le film semiconducteur au contact du support isolant et donc d'éviter la mise en goutte du silicium ainsi que de limiter le transport de masse de silicium fondu.

A ce sujet, de récentes études utilisant un faisceau d'énergie non cohérente pour recristalliser le film de silicium, ont montré qu'un relief de motif gravé dans la couche d'oxyde de silicium supportant le film de silicium pouvait améliorer la tenue du silicium liquide, tout au moins dans les parties en creux du relief. Ces études ont notamment fait l'objet d'une publication de W. SCHARFF et al., paru dans Thin Solid Film, 113 (1984), p.327-335, intitulé "Growth of monocrystalline silicon islands on Insulations substrates".

Par ailleurs, on tente généralement d'éviter la mise en goutte du silicium en recouvrant le film de silicium d'une couche épaisse d'oxyde de silicium ou de nitrure de silicium (2 μm pour un film de silicium de 0,5 μm). Mais même avec de telles épaisseurs de matériau, il arrive souvent que le silicium se mette en goutte, conduisant à l'obtention de plaquettes de silicium totalement inutilisables.

La présente invention a justement pour objet un procédé de fabrication d'un film de silicium monocristallin sur un support isolant permettant de remédier aux différents inconvénients cités ci-dessus. Ce procédé, utilisant notamment la technique de fusion de zones pour former le film semi-conducteur monocristallin, permet une localisation précise des défauts de cristallisation et la formation de monocristaux de silicium orientés (100), c'est-à-dire perpendiculairement au plan du film de silicium et parallèlement au sens de déplacement de la ligne fondue.

De façon plus précise, l'invention a pour objet un procédé de fabrication d'un film de silicium monocristallin sur un support isolant comprenant les étapes successives suivantes :

a) - recouvrement d'un substrat en silicium monocristallin d'orientation donnée d'une couche d'un matériau isolant,

b) - réalisation dans la couche isolante, par une première gravure de ladite couche isolante, de bandes en surplomb et de bandes en creux, parallèles et alternées, d'orientation proche d'une orientation (100) du substrat, la largeur des bandes en surplomb étant plus faible que celle des bandes en creux,

c) - réalisation d'une seconde gravure de la couche isolante afin de former localement aux extrémités de ladite couche au moins une ouverture, cette seconde gravure étant réalisée jusqu'à mise à nu du substrat,

d) - dépôt sur la couche isolante gravée d'un film de silicium,

e) - recouvrement du film de silicium d'une couche d'un matériau encapsulant,

f) - réalisation d'un traitement thermique de la structure obtenue afin de recristalliser le film de silicium sous forme monocristalline de même orientation que les bandes isolantes, et

g) - élimination de la couche de matériau encapsulant.

La réalisation, par gravure du support isolant, de bandes en surplomb et de bandes en creux parallèles permet une bonne localisation des défauts résiduels de cristallisation du film de silicium.

En effet, les parties ou bandes en surplomb assurent la localisation des joints et sous-joints de grains grâce à une modulation de l'isotherme du front de cristallisation : la solidification est retardée dans les zones d'isolant les plus épaisses (parties en surplomb), du fait de la différence de conductivité thermique entre l'isolant épais et l'isolant mince. Les défauts de cristallisation sont donc localisés juste au-dessus des marches isolantes.

Par ailleurs, la configuration des bandes en surplomb et en creux permet d'éviter la mise en goutte du silicium en fusion sur l'isolant, lorsque celui-ci est de l'oxyde de silicium, ce qui permet notamment l'utilisation de couches de matériau encapsulant plus faibles que celles de l'art antérieur. Si, par hasard le silicium se mettait en goutte, le liquide resterait toutefois confiné entre deux parties en surplomb, le franchissement de ces parties en surplomb ou marches étant difficile.

La réalisation des ouvertures aux extrémités de la couche isolante, situées de préférence dans les bandes isolantes en creux, permet d'utiliser le substrat monocristallin comme germe de recristallisation du film de silicium, ce qui permet d'orienter le film et d'éviter les désorientations qui sont les causes principales d'apparitions de joints et sous-joints de grain.

De façon avantageuse le substrat présente une orientation cristalline (100). En effet, il semblerait que plus l'orientation cristalline s'éloigne de l'orientation (100), plus le film de silicium recristallisé comporterait des défauts.

Selon un mode préféré de mise en oeuvre du procédé de l'invention, l'étape f consiste à fondre localement le film de silicium et à déplacer la zone fondue parallèlement aux bandes isolantes, la zone fondue ayant la forme d'un trait perpendiculaire auxdites bandes.

De façon avantageuse, la zone fondue de silicium, ayant la forme d'un trait perpendiculaire aux bandes isolantes en surplomb ou en creux, est obtenue en soumettant l'ensemble de la structure à l'action d'une raie d'énergie, perpendiculaire à ces bandes isolantes, se déplaçant parallèlement à elles.

De façon à bien guider l'orientation cristalline du film de silicium recristallisé, la zone fondue sera déplacée à une vitesse lente, c'est-à-dire à une vitesse inférieure à 0,5 mm/s. De préférence, la vitesse de déplacement de la zone fondue varie de 0,1 0,2 mm/s.

De façon avantageuse, on utilise une configuration périodique, dans laquelle les parties en surplomb et les parties en creux sont régulièrement espacées les unes des autres. Ceci permet d'obtenir lors du traitement thermique, une répartition homogène de l'énergie absorbée et diffusée dans le film de silicium et le long de la zone fondue qui est perpendiculaire aux bandes isolantes.

L'utilisation d'une configuration périodique est particulièrement intéressante pour des raisons de traitement technologique ultérieur (réalisation de circuits intégrés). En effet, les concepteurs de circuits intégrés souhaitent pouvoir disposer des plus grandes régions monocristallines possibles sans défaut. Dès lors qu'une largeur critique des parties isolantes en creux a été déterminée, il est préférable de la répéter afin d'éviter une perte de place, en cas de diminution de cette largeur, ou une apparition de défauts, en cas d'augmentation de ladite largeur. De plus, une configuration périodique peut être intéressante lors de la fabrication de composants ou circuits reproduits périodiquement (matrice, mémoire, réseaux pré-diffusés, etc...).

En cas de nécessité, on peut aplanir la surface du film de silicium déposé avant de le recristalliser. Ceci peut avantageusement être obtenu par la technique dite "de planarisation" consistant à recouvrir le film de silicium d'une couche d'un matériau isolant, et en particulier d'une résine telle que celle généralement utilisée en photolithographie, puis graver simultanément cette couche de matériau isolant et le film de silicium, à des vitesses d'attaque identiques pour l'isolant et le silicium, jusqu'à élimination totale de l'isolant et des parties en relief du film de silicium.

De façon avantageuse, les gravures de la couche isolante pour former la configuration périodique et/ou les ouvertures sont réalisées par un procédé de gravure ionique réactive permettant ainsi d'obtenir des flancs gravés raides.

Ces flancs raides améliorent notamment le mouillage du silicium liquide sur le support isolant ou plutôt bloquent la mise en goutte du silicium fondu.

D'autres caractéristiques et avantages de l'invention ressortiront mieux de la description qui va suivre, donnée à titre illustratif et non limitatif en référence aux figures annexées, dans lesquelles :

- les figures 1, 2, 4, 6 à 8 sont des vues en coupe longitudinale, représentant les différentes étapes du procédé de fabrication d'un film de silicium monocristallin conformément à l'invention : les figures 4 et 6 illustrent les mêmes étapes du procédé, la figure 4 correspondant à une coupe au niveau des ouvertures de germination et la figure 6 une coupe en plein milieu de la structure ; et

- les figures 3 et 5 sont des vues de dessus montrant diverses formes d'ouverture de germination.

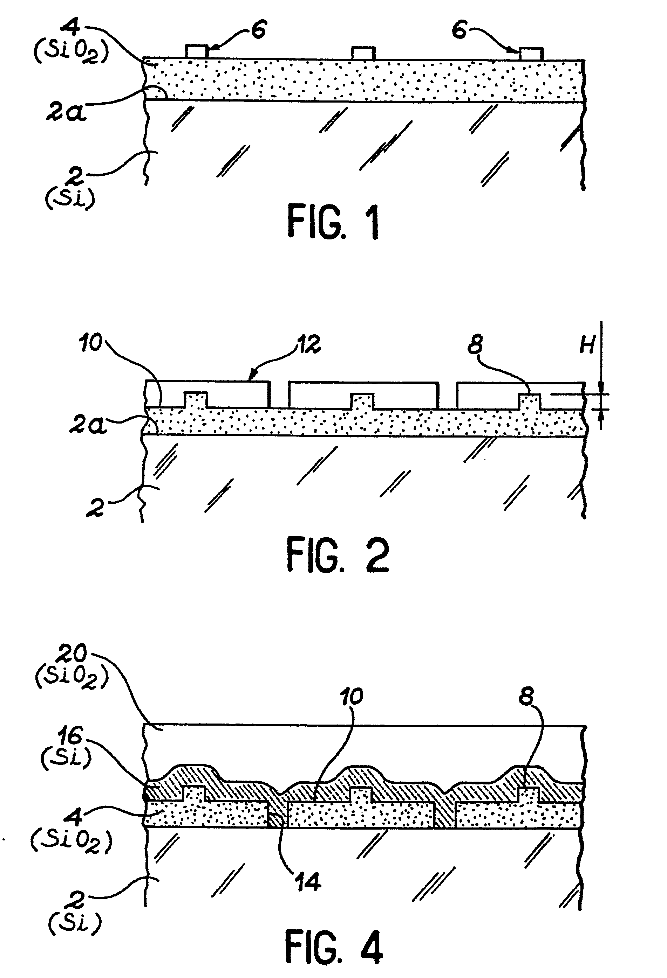

La première étape du procédé, comme représenté sur la figure 1, consiste à recouvrir totalement la surface 2a d'un substrat de silicium monocristallin 2 d'une couche de matériau isolant 4. Le substrat en silicium 2 présente par exemple une orientation cristalline (100), c'est-à-dire une orientation perpendiculaire à la surface 2a du substrat. La couche de matériau isolant 4 peut être réalisée soit en oxyde de silicium, soit en nitrure de silicium.

Dans le cas d'une couche 4 en oxyde de silicium, celle-ci peut être obtenue par oxydation thermique du substrat 2, sous oxygène sec ou humide à une température de 800 à 1100°C, par exemple de 1000°C. Cette couche d'oxyde 4 présente par exemple une épaisseur de 0,5 à 1,5 μm.

On réalise ensuite sur la couche isolante 4 un masque de gravure 6 permettant de définir l'emplacement et les dimensions des parties en surplomb ou marches à réaliser dans la couche isolante 4. Ce masque 6 est par exemple un masque de résine réalisé selon les procédés classiques de photolithographie.

On effectue ensuite à travers le masque 6, comme représenté sur la figure 2, une première gravure de la couche isolante 4 afin d'éliminer sur une hauteur H les régions de l'isolant non recouvertes de résine. Dans le cas d'une couche 4 d'oxyde de silicium de 1 μm d'épaisseur, cette hauteur H peut aller de 200 à 500 nm et par exemple égale à 400 nm.

Afin d'obtenir des flancs gravés bien droits, la gravure de la couche d'isolant peut être réalisée de façon anisotrope au moyen d'un procédé de gravure ionique réactive (GIR), utilisant comme agent d'attaque un plasma de tétrafluorure de carbone ($CF_4$) ou de trifluorométhane ($CHF_3$) dans le cas d'une couche 4 en oxyde de silicium.

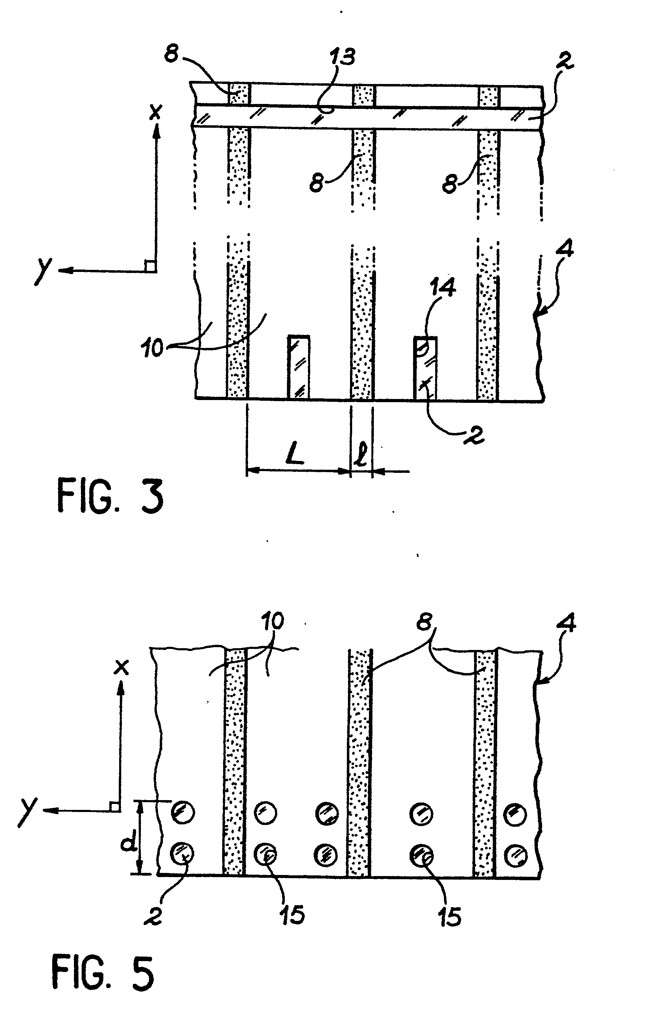

Cette gravure de la couche isolante 4 permet la formation d'une configuration, de préférence périodique, comportant des parties en surplomb ou marches 8 similaires et des parties en creux 10 semblables. Ces parties en surplomb 8 et en creux 10 présentent, comme représenté sur la figure 3, la forme de bandes isolantes parallèles qui sont de préférence règulièrement espacées les unes de autres. Ces bandes isolantes 8 et 10 s'étendent avantageusement d'un bord à l'autre de la structure, selon une direction X, et sont situées dans le plan de la couche isolante ; leur direction dans le plan est proche d'une des directions (100) du substrat.

La largeur L des parties en creux 10, au-dessus desquelles pourront être réalisées les zones actives des circuits intégrés, est supérieure à la largeur l des parties en surplomb ou marches 8. Par exemple les parties en surplomb 8, au-dessus desquelles seront localisés les défauts de cristallisation (joints, sous-joints de grains) du film de silicium monocristallin à réaliser, présentent une largeur l pouvant varier de 3 à 6 μm, par exemple égale à 4 μm. En revanche, les zones en creux peuvent présenter une largeur L allant de 20 à 100 μm pour un substrat de 100 mm de côté, par exemple de 36 μm.

Après gravure de la couche isolante 4, on élimine le masque de résine 6 par exemple par voie chimique en utilisant comme agent d'attaque de l'acétone ou de l'acide nitrique ou par l'action d'un plasma d'oxygène, pour un masque obtenu avec une résine photosensible positive.

Sur la structure obtenue, représentée sur la figure 2, on réalise un second masque de gravure 12 par exemple en résine, selon les procédés classiques de photolithographie, permettant de définir l'emplacement et les dimensions d'une ou plusieurs ouvertures à réaliser localement dans la couche isolante 4 et de préférence dans les parties ou bandes en creux 10 de cette couche isolante 4.

On effectue alors, comme représenté sur les figures 3 à 5, une deuxième gravure de la couche isolante 4 afin d'éliminer totalement les parties de cette couche isolante 4 non recouvertes de résine et donc de former une ou des ouvertures débouchant sur le substrat 2. Ces ouvertures permettront, lors de la recristallisation du film de silicium, d'utiliser le substrat monocristallin 2 comme germe pour donner une orientation cristalline du film de silicium, dans toutes les parties en creux isolantes 10, voisine de celle du substrat. Comme précédemment, cette gravure est réalisée de préférence de façon anisotrope afin de former des flancs raides. Cette gravure est par exemple une gravure ionique réactive utilisant comme agent d'attaque un plasma de tétrafluorure de carbone ou du trifluorométhane pour une couche 4 en oxyde de silicium.

La ou les ouvertures de germination peuvent avoir différentes formes. En particulier, comme représenté sur la figure 3, il est possible d'utiliser une seule ouverture ayant la forme d'une bande 13 orientée suivant une direction Y perpendiculaire à la direction X et donc aux bandes isolantes 8 et 10. Cette bande 13 s'étend avantageusement d'un bord à l'autre de la couche isolante 4. Elle peut présenter une largeur allant de 1 à 10 μm.

On peut également utiliser plusieurs ouvertures 14 de germination ayant par exemple une forme parallélépipédique. Ces ouvertures 14 peuvent avantageusement être situées au milieu des parties en creux 10 de la couche isolante 4, une ouverture par partie en creux, pour des raisons de symétrie de croissance du silicium. Ces ouvertures 14 peuvent présenter une longueur de plusieurs millimètres sur une largeur allant de 2 à 20 μm.

On peut aussi utiliser plusieurs trous 15, comme représenté sur la figure 5, ayant un diamètre allant de 2 à 10 μm, par exemple égal à 5 μm et séparés les uns des autres de 10 à 100 μm et par exemple de 30 μm. Ces trous 15 peuvent notamment être situés dans les parties en creux 10 de la couche isolante 4 et disposés sous forme de rangées, parallèles à la direction Y et donc perpendiculaires auxdites parties 10. La distance d sur laquelle sont pratiqués les trous est par exemple égale à 1,5 cm.

Quels que soient la forme et le nombre d'ouvertures de germination réalisée, celles-ci doivent se trouver aux extrémités de la couche isolante 4, et principalement aux extrémités d'où partent les bandes isolantes en surplomb 8 et en creux 10.

Après réalisation de l'ouverture ou des ouvertures de germination, on élimine le masque de résine 8 (figure 2) par exemple par voie chimique en utilisant comme agent d'attaque de l'acétone ou de l'acide nitrique ou par action d'un plasma d'oxygène, pour un masque obtenu avec une résine photosensible positive.

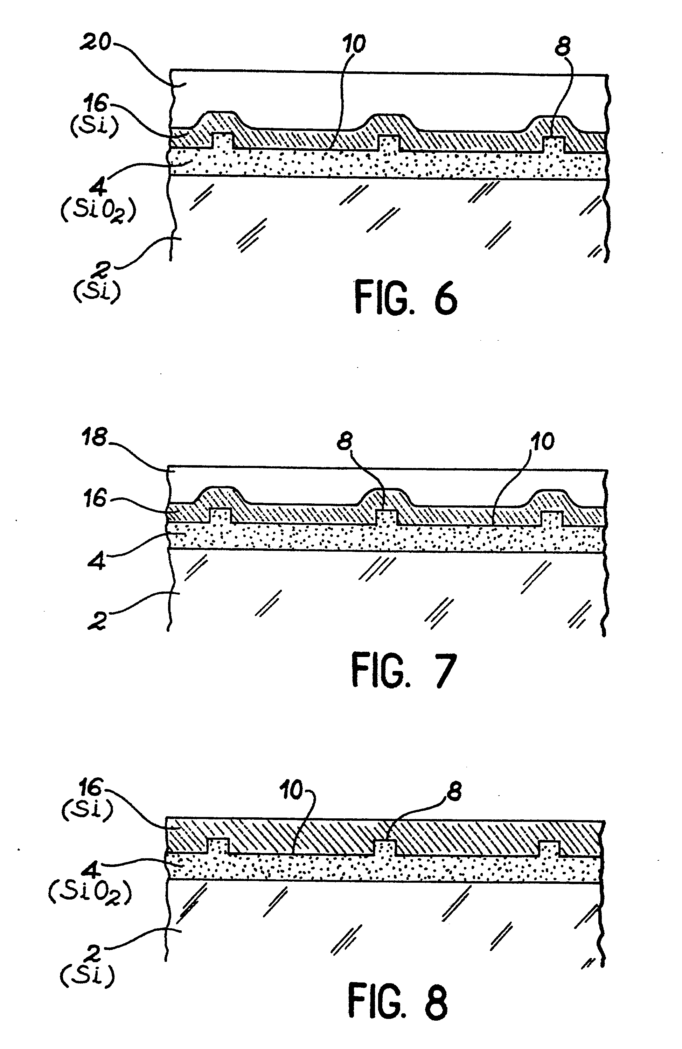

L'étape suivante du procédé, comme représenté sur les figures 3 et 6, consiste à recouvrir l'ensemble de la structure d'un film de silicium 16 ; ce silicium peut être soit du silicium amorphe, soit du silicium polycristallin. Ce film de silicium 16 présente une épaisseur allant de 0,1 à 1 µm et par exemple égal à 0,5 µm. Lorsque le silicium déposé est du silicium polycristallin, le film de silicium peut être obtenu par un procédé de dépôt chimique en phase vapeur à basse pression (LPCVD), à une température de l'ordre de 625°C par pyrolyse de $SiH_4$.

Au cas où le film de silicium 16 ne présenterait pas une surface plane (figures 4 et 6), ce qui est le cas lorsque les parties en surplomb ou marches 8 sont relativement élevées par rapport à l'épaisseur du film de silicium, il est préférable d'aplanir cette surface par un procédé dit "de planarisation".

Cet aplanissement de la surface du film de silicium 16 (figure 8) peut par exemple être obtenu en recouvrant, comme représenté sur la figure 7, ce film 16 d'une couche d'un matériau isolant 18 effaçant le relief du film de silicium 16. Cette couche isolante 18 est de préférence réalisée en résine telle que celle couramment utilisée en photolithographie. Le dépôt de cette couche de résine 18, présentant notamment une épaisseur de quelques µm, peut être suivi d'un traitement thermique, par exemple un chauffage à la température de l'ordre de 100°C pendant 30 mn, de façon à obtenir un bon étalement de cette couche de résine 18.

On réalise ensuite une gravure simultanée de la couche de résine 18 et du film de silicium 16, à des vitesses d'attaque identiques pour la résine et le silicium, jusqu'à élimination totale, comme représenté sur la figure 8, de la couche de résine 18 et donc des zones en relief du film de silicium 16. Cette gravure est réalisée de préférence de façon anisotrope, par exemple par un procédé de gravure ionique réactive utilisant comme agent d'attaque un plasma d'hexafluorure de soufre et d'oxygène : le composé fluoré servant à la gravure du silicium et l'oxygène servant à la gravure de la résine.

L'étape suivante du procédé, comme représenté sur les figures 4 et 6, consiste à recouvrir le film de silicium 16 éventuellement aplani, d'une couche d'encapsulation 20 réalisée par exemple en oxyde de silicium ou en nitrure de silicium ou même sous forme d'un matériau bi-couche. Cette couche de matériau encapsulant, présente notamment une épaisseur allant de 1 à 2 µm et par exemple de 1,6 µm. Elle peut être obtenue par un procédé de dépôt chimique en phase vapeur à basse pression et basse température (LTO), par exemple à 430°C par pyrolyse de $SiH_4+O_2$, lorsque ladite couche est en oxyde de silicium, ou par pulvérisation cathodique lorsque cette couche est en nitrure de silicium.

L'étape suivante du procédé consiste à soumettre la structure obtenue, représentée sur les figures 4 et 6, à un traitement thermique permettant de recristalliser le film de silicium 16 sous forme monocristalline.

Les germes de recristallisation du silicium peuvent être obtenus par épitaxie latérale du substrat 2, lors de ce traitement thermique. En fait, ces zones de germination à partir du substrat 2 peuvent être obtenues de toutes les façons actuellement connues par l'homme du métier, car peu importe leur qualité, seule leur orientation, par exemple (100), est importante.

Le traitement thermique comprend tout d'abord une étape de préchauffage consistant à placer l'ensemble de la structure dans un four et à porter celle-ci à une température inférieure à la température de fusion du silicium qui est voisine de 1410°C. Par exemple la structure peut être portée à une température allant de 800 à 1200°C et notamment à 1100°C.

Après l'étape de préchauffage, on fond localement le film de silicium 16 dans la zone des ouvertures de germination et on déplace la zone fondue ainsi obtenue selon une direction X (figures 3 et 5) parallèle aux bandes isolantes 8, suivant une vitesse relativement lente et notamment inférieure à 0,5 mm/s. De préférence, la vitesse de balayage de la zone fondue varie de 0,1 à 0,2 mm/s.

La zone fondue de silicium présente la forme d'un trait de par exemple 2 à 5 mm de large et dont la longueur est au moins égale à celle d'une plaquette de silicium de type industriel (100 mm de diamètre). Ce trait ou ligne de zone fondue peut par exemple être réalisé en soumettant la surface de la structure à une raie d'énergie notamment de 2 à 5 mm de large orientée selon la direction Y, perpendiculaire aux bandes isolantes 8. Cette raie d'énergie se déplace parallèlement auxdites bandes selon la direction X.

Cette raie d'énergie peut avantageusement être réalisée à l'aide d'un barreau de graphite chauffé ou d'une lampe linéaire focalisée à la surface de la structure. Un dispositif de chauffage utilisable dans l'invention est notamment celui décrit dans la demande de brevet français n° 2 532 783.

L'étape suivante du procédé consiste à éliminer la couche de matériau encapsulant 20 par attaque chimique dans un bain d'acide fluorhydrique lorsque cette couche est réalisée en oxyde de silicium. La structure finale est celle représentée sur la figure 8.

Le procédé décrit précédemment permet d'obtenir de larges bandes (parties en creux 10) de silicium constituées chacune d'un monocristal exempt de défaut, par exemple de 36 µm de large et de 100 mm de long, présentant une orientation (100), sur lesquelles peuvent être réalisées les zones actives des circuits intégrés notamment MOS ou bipolaires ; les défauts résiduels tels que les joints et sous-joints de grains ou autres dislocations, qui ne peuvent être supprimés lors de la recristallisation du film de silicium, sont exclusivement situés entre ces bandes monocristallines, c'est-à-dire au niveau des marches 8, typiquement de 4 µm de large et 100 mm de long. Les bandes de silicium monocristallin peuvent être considérées indépendantes les unes des autres.

Les différentes étapes du procédé selon l'invention présentent l'avantage d'être simples, facilement reproductibles et d'être bien maîtrisées par l'homme du métier.

En cas de nécessité, les zones de silicium ayant servi de germes à la croissance monocristalline du film de silicium 16, c'est-à-dire les zones du film surmontant les ouvertures pratiquées dans la couche isolante 4 peuvent être isolées du reste de la structure, par exemple en effectuant une oxydation thermique localisée de ces zones.

La description donnée précédemment n'a bien entendu été donnée qu'à titre explicatif, toutes modifications, sans pour autant sortir du cadre de l'invention, pouvant être envisagées.

En particulier, l'épaisseur des différentes couches, la nature de celles-ci ainsi que leurs procédés de dépôt et leurs procédés de gravure peuvent être modifiés. De même, les dimensions des bandes isolantes 8 et 10 et des ouvertures de germination peuvent être modifiées. En outre, leur disposition ne forme pas nécessairement une structure périodique.

Par ailleurs, certaines étapes du procédé peuvent être, dans certains cas, supprimées. Dans le cas d'un film de silicium épais (environ 1 µm), les différentes techniques de dépôt de silicium connues par l'homme du métier permettent d'obtenir un film comportant une surface suffisamment plane, sans pour cela utiliser l'étape dite de "planarisation".

De plus, pour une hauteur H de marche 8 faible, de 0,2 µm par exemple, l'étape de "planarisation" même pour un film de silicium de 0,5 µm d'épaisseur, ne sera pas nécessaire.

En outre, le traitement thermique permettant la cristallisation du film de silicium peut être réalisé avec un autre procédé que celui décrit. En particulier, la raie d'énergie peut être réalisée à l'aide d'un faisceau laser ou d'électrons focalisé à la surface de la structure balayant rapidement ladite surface selon la direction Y, perpendiculairement aux bandes isolantes.

## Revendications

1. Procédé de fabrication d'un film de silicium monocristallin sur un support isolant comprenant les étapes successives suivantes :
   a) recouvrement d'un substrat en silicium monocristallin (2) d'orientation donnée d'une couche d'un matériau isolant (4),
   b) réalisation dans la couche isolante (4), par une première gravure de ladite couche isolante, de bandes en surplomb (8) et de bandes en creux (10), parallèles et alternées, d'orientation proche d'une orientation (100) du substrat, la largeur des bandes en surplomb étant plus faible que celle des bandes en creux,
   c) réalisation d'une seconde gravure de la couche isolante (4) afin de former localement aux extrémités de ladite couche au moins une ouverture (13, 14, 15), cette seconde gravure étant réalisée jusqu'à mise à nu du substrat,
   d) dépôt sur la couche isolante (4) gravée d'un film de silicium (16),
   e) recouvrement du film de silicium d'une couche (20) d'un matériau encapsulant,
   f) réalisation d'un traitement thermique de la structure obtenue afin de recristalliser le film de silicium (16) sous forme monocristalline de même orientation que les bandes isolantes (8, 10), et
   g) élimination de la couche de matériau encapsulant (20).

2. Procédé de fabrication selon la revendication 1, caractérisé en ce que le substrat (2) a une orientation cristalline (100).

3. Procédé de fabrication selon la revendication 1 ou 2, caractérisé en ce que l'étape f consiste à fondre localement le film de silicium (16) et à dépla cer la zone fondue parallèlement aux bandes isolantes (8, 10), la zone fondue ayant la forme d'un trait perpendiculaire auxdites bandes (8, 10).

4. Procédé de fabrication selon la revendication 3, caractérisé en ce que l'on déplace la zone fondue à une vitesse inférieure à 0,5 mm/s.

5. Procédé de fabrication selon l'une quelconque des revendications 3 et 4, caractérisé en ce que l'on déplace la zone fondue à une vitesse allant de 0,1 à 0,2 mm/s.

6. Procédé de fabrication selon l'une quelconque des revendications 1 à 5, caractérisé en ce que l'on réalise le traitement thermique en soumettant la structure à l'action d'une raie d'énergie perpendiculaire aux bandes isolantes (8, 10) et se déplaçant parallèlement auxdites bandes (8, 10).

7. Procédé de fabrication selon l'une quelconque des revendications 1 à 6, caractérisé en ce que les ouvertures (13, 14, 15) sont situées dans les bandes en creux (10).

8. Procédé de fabrication selon l'une quelconque des revendications 1 à 7, caractérisé en ce que les bandes en surplomb et les bandes en creux sont disposées selon une configuration périodique.

9. Procédé de fabrication selon l'une quelconque des revendications 1 à 8, caractérisé en ce que la première et/ou la seconde gravures de la couche isolante (4) sont des gravures ioniques réactives.

10. Procédé de fabrication selon l'une quelconque des revendications 1 à 9, caractérisé en ce que la couche isolante (4) et/ou la couche de matériau encapculant (20) sont réalisées en oxyde de silicium.

11. Procédé de fabrication selon l'une quelconque des revendications 1 à 10, caractérisé en ce que l'étape d consiste à déposer un film (16) de silicium amorphe ou polycristallin.

12. Procédé de fabrication selon l'une quelconque des revendications 1 à 11, caractérisé en ce que, avant l'étape f, on dépose une couche d'un autre matériau isolant (18) sur le film de silicium (16) effaçant le relief du film de silicium et on grave simultanément ladite couche de matériau isolant (18) et le film de silicium (16) à des vitesses d'attaque identiques pour l'isolant et le silicium, jusqu'à élimination totale de ladite couche de matériau isolant (18) et des parties en relief du film de silicium (16), afin d'aplanir la surface dudit film.

## Patentansprüche

1. Verfahren zum Herstellen eines Films aus monokristallinem Silicium auf einem isolierenden Träger, umfassend die folgenden aufeinanderfolgenden Schritte:

a) Bedecken eines Substrats aus monokristallinem Silicium (2) einer gegebenen Orientierung mit einer Schicht aus einem isolierenden Material (4),

b) Ausbilden von vorstehenden Bändern (8) und vertieften Bändern (10), die parallel zueinander verlaufen und sich abwechseln in der isolierenden Schicht (4) durch eine erste Ätzung der isolierenden Schicht mit einer Orientierung, die einer Orientierung (100) des Substrats nahekommt, wobei die Breite der vorstehenden Bänder kleiner als die der vertieften Bänder ist,

c) Ausführen einer zweiten Ätzung der isolierenden Schicht (4), um örtlich an den Enden der genannten Schicht wenigstens eine Öffnung (13, 14, 15) auszubilden, wobei diese zweite Ätzung bis zur Freilegung des Substrats ausgeführt wird,

d) Aufbringen eines Siliciumfilms (16) auf die geätzte isolierende Schicht (4),

e) Bedecken des Siliciumfilms mit einer Schicht (20) aus einem Vergussmaterial,

f) Ausführen einer thermischen Behandlung der erhaltenen Struktur, um den Siliciumfilm (16) monokristallin mit gleicher Orientierung wie die isolierenden Bänder (8, 10) zu rekristallisieren, und

g) Entfernen der Schicht aus dem Vergussmaterial (20).

2. Herstellungsverfahren nach Anspruch 1, dadurch gekennzeichnet, daß das Substrat (2) eine kristalline Orientierung (100) hat.

3. Herstellungsverfahren nach Anspruch 1 oder 2, dadurch gekennzeichnet, dass der Schritt f) darin besteht, örtlich den Siliciumfilm (16) zu schmelzen und die geschmolzene Zone parallel zu den isolierenden Bändern (8, 10) zu verschieben, wobei die geschmolzene Zone die Form eines zu den genannten Bändern (8, 10) senkrechten Striches hat.

4. Herstellungsverfahren nach Anspruch 3, dadurch gekennzeichnet, dar man die geschmolzene Zone mit einer Geschwindigkeit von weniger als 0,5 mm/s verschiebt.

5. Herstellungsverfahren nach einem der Ansprüche 3 und 4, dadurch gekennzeichnet, daß man die geschmolzene Zone mit einer Geschwindigkeit von 0,1 bis 0,2 mm/s verschiebt.

6. Herstellungsverfahren nach einem der Ansprüche 1 bis 5, dadurch gekennzeichnet, dass man die thermische Behandlung dadurch ausführt, daß man die Struktur der Wirkung eines Energiestrahls unterwirft, der senkrecht zu den isolierenden Bändern (8, 10) ist und sich parallel zu den genannten Bändern (8, 10) verschiebt.

7. Herstellungsverfahren nach einem der Ansprüche 1 bis 6, dadurch gekennzeichnet, dass die Öffnungen (13, 14, 15) in den vertieften Bändern (10) angeordnet sind.

8. Herstellungsverfahren nach einem der Ansprüche 1 bis 7, dadurch gekennzeichnet, dass die vorstehenden Bänder und die vertieften Bänder in einer periodischen Konfiguration angeordnet sind.

g. Herstellungsverfahren nach einem der Ansprüche 1 bis 8, dadurch gekennzeichnet, daß die erste Ätzung und/oder die zweite Ätzung der isolierenden Schicht (4) reaktive ionische Ätzungen sind.

10. Herstellungsverfahren nach einem der Ansprüche 1 bis 9, dadurch gekennzeichnet, dass die isolierende Schicht (4) und/oder die Schicht aus Vergußmaterial (20) aus Siliciumoxid bestehen.

11. Herstellungsverfahren nach einem der Ansprüche, bis 10, dadurch gekennzeichnet, daß der Schritt d) darin besteht, einen Film (16) aus amorphem oder polykristallinem Silicium anzubringen.

12. Herstellungsverfahren nach einem der Ansprüche 1 bis 11, dadurch gekennzeichnet, daß man vor dem Schritt f) eine Schicht aus einem anderen Isoliermaterial (18) auf den Siliciumfilm (16) aufbringt, die das Relief des Siliciumfilms einebnet, und daß man die genannte Schicht aus isolierendem Material (18) und den Siliciumfilm (16) gleichzeitig mit gleichen Angriffsgeschwindigkeiten für das Isoliermaterial und das Silicium bis zur vollständigen Entfernung der genannten Schicht aus isolierendem Material (15) und der Reliefabschnitte des Siliciumfilms (16) ätzt, um die Oberfläche des genannten Films einzuebnen.

**Claims**

1. Process for the production of a monocrystalline silicon film on an insulating support comprising the following successive stages:

a) covering a monocrystalline silicon substrate (2) of given orientation with an insulating material layer (4),

b) forming in the insulating layer (4), by a first etching thereof, overhanging strips (8) and recessed strips (10), which are parallel and alternate, with an orientation close to an orientation (100) of the substrate, the widths of the overhanging strips being smaller than that of the recessed strips,

c) producing a second etching of the insulating layer (4) in order to locally form at the ends of said layer at least one opening (13, 14, 15), said second etching being continued until the substrate is exposed,

d) depositing on the etched insulating layer (4) a silicon film (16),

e) covering the silicon film with a layer (20) of an encapsulating material,

f) carrying out a heat treatment of the structure obtained in order to recrystallize the silicon film (16) in monocrystalline form with the same orientation as the insulating strips (8, 10) and,

g) eliminating the encapsulating material layer (20).

2. Production process according to claim 1, characterized in that the substrate (2) has a crystalline orientation (100).

3. Production process according to claims 1 or 2, characterized in that stage f) consists of locally melting, the silicon film (16) and moving the melted zone parallel to the insulating strips (8, 10), the melted zone being in the form of a line perpendicular to said strips (8, 10).

4. Production process according to claim 3, characterized in that the melted zone is moved at a speed below 0.5 mm/s.

5. Production process according to either of the claims 3 and 4, characterized in that the melted zone is moved at a speed of 0.1 to 0.2 mm/s.

6. Production process according to any one of the claims 1 to 5, characterized in that the heat treatment is performed by subjecting the structure to the action of an energy line perpendicular to the insulating strips (8, 10) and moving parallel to the latter (8, 10).

7. Production process according to any one of the claims 1 to 6, characterized in that the openings (13, 14, 15) are located in the recessed strips (10).

8. Production process according to any one of the claims 1 to 7, characterized in that the overhanging strips and the recessed strips are arranged according to a periodic configuration.

9. Production process according to any one of the claims 1 to 8, characterized in that the first and/or second etchings of the insulating layer (4) are reactive ionic etchings.

10. Production process according to any one of the claims 1 to 9, characterized in that the insulating layer (4) and/or the encapsulating material layer (20) are made from silicon oxide.

11. Production process according to any one of the claims 1 to 10, characterized in that stage d) consists of depositing an amorphous or polycrystalline silicon film (16).

12. Production process according to any one of the claims 1 to 11, characterized in that before stage f), a layer of another insulating material layer (18) is deposited on the silicon film (16) cancelling out the relief of the silicon film, followed by the simultaneous etching of said insulating material layer (18) and the silicon film (16) at identical etching speeds for the insulant and the silicon, until the insulating material layer (18) and the relief parts of the silicon film (16) are completely eliminated, in order to flatten the surface of said film.

EP 0 202 977 B1

FIG. 1

FIG. 2

FIG. 4

FIG. 3

FIG. 5

20

10

8

16
(Si)

4
(SiO$_2$)

2
(Si)

## FIG. 6

18

8

10

16

4

2

## FIG. 7

16
(Si)

10

8

4
(SiO$_2$)

2
(Si)

## FIG. 8